(19) Europäisches Patentamt
European Patent Office
Office européen des brevets

(11) **EP 2 754 997 B1**

(12) **EUROPÄISCHE PATENTSCHRIFT**

(45) Veröffentlichungstag und Bekanntmachung des Hinweises auf die Patenterteilung:
**21.09.2016 Patentblatt 2016/38**

(21) Anmeldenummer: **14000111.6**

(22) Anmeldetag: **13.01.2014**

(51) Int Cl.:
*G01D 5/14* *(2006.01)*    *G01R 33/09* *(2006.01)*

(54) **Messsystem**

Measuring system

Système de mesure

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.01.2013 DE 102013000432**

(43) Veröffentlichungstag der Anmeldung:
**16.07.2014 Patentblatt 2014/29**

(73) Patentinhaber: **Micronas GmbH**
**79108 Freiburg (DE)**

(72) Erfinder:
• **Ritter, Joachim**
**79540 Lörrach (DE)**

• **Jörg, Franke**
**79117 Freiburg (DE)**

(74) Vertreter: **Koch Müller**
**Patentanwaltsgesellschaft mbH**
**Maaßstraße 32/1**
**69123 Heidelberg (DE)**

(56) Entgegenhaltungen:
EP-A1- 2 354 769       EP-A2- 2 339 299
WO-A1-2012/060216    JP-A- 2003 194 901
US-A1- 2008 044 119    US-A1- 2012 262 157

**Beschreibung**

Die vorliegende Erfindung betrifft ein Messsystem.

Aus der EP 2 354 769 A1 sind ein Winkelgeber und ein Verfahren zur Bestimmung eines Winkels zwischen einer Sensoranordnung und einem Magnetfeld bekannt. Der Winkelgeber weist einen das Magnetfeld erzeugenden, bezüglich einer Drehachse in unterschiedliche Drehlagen relativ zu der Sensoranordnung verstellbaren Magneten auf. Die Sensoranordnung weist einen ersten Magnetfeldsensor zur Erfassung einer quer zur Drehachse orientierten ersten Magnetfeldkomponente und einen zweiten Magnetfeldsensor zur Erfassung einer zweiten Magnetfeldkomponente auf, die quer zu einer von der Drehachse und der ersten Magnetfeldkomponente aufgespannten Ebene angeordnet ist. Die Sensoranordnung weist einen dritten Magnetfeldsensor zur Erfassung einer in Richtung der Drehachse orientierten dritten Magnetfeldkomponente auf. Ferner sind aus der US 2012 /262157 A1, der US 2008 / 044 119 A1, der JP 2003 194901 A, der EP 2 339 299 A2 und der WO 2012 / 060216 A1 weitere Magnetfeldsensoranordnungen und Messsysteme bekannt.

Aus der DE 10 2008 059 401 A1 ist ein Halbleiterchip und ein Verfahren zum Erzeugen von Impulsflanken bekannt, die der Bewegung eines mechanischen Teils synchron zugeordnet sind. Ein Magnetfeld wird erzeugt und mindestens zwei Messsignale werden für das Magnetfeld erfasst. Das Magnetfeld wird derart in Abhängigkeit von der Bewegung des mechanischen Teils verändert, dass die Messsignale zueinander phasenverschoben moduliert werden. Ein erstes Messsignal wird mit einem ersten Referenzwert verglichen. Ein zweites Messsignal wird mit einem zweiten Referenzwert verglichen. Der Betrag des ersten Messsignals wird mit dem Betrag des zweiten Messsignals verglichen. Eine Impulsflanke wird erzeugt, wenn mindestens einer dieser Vergleiche eine Übereinstimmung ergibt oder das Ergebnis des betreffenden Vergleichs sein Vorzeichen ändert.

Aus der EP 1 111 392 A1 ist ein Erfassen der Drehzahl und Winkelstellung eines rotierenden Rades mit anpassbarer Schaltschwelle zur Driftkompensation bekannt. Das Erfassen der Drehzahl und der

Winkelstellung eines Rades erfolgt mittels eines berührungslos das Rad abtastenden Sensors, der eine Impulsfolge erzeugt. Die Amplitude der Impulse wird in einem Vergleicher mit einer variablen Schaltschwelle verglichen. Die Schaltschwelle wird so angepasst, dass der Betrag der Differenz zwischen den Amplituden der Impulse und der Schaltschwelle einen vorgebbaren Höchstwert nicht überschreitet.

Aus ELEKTRONIK PRAXIS, Nr. 18, 17. Sept. 2008, Seite 22, J. Quasdorf ist ein optisches Nonius-System bekannt. Die Interpolation analoger Sinussignale ist eine Auswertefunktion bei Positionssensoren. Mit einem speziellen Verfahren ist es möglich, mehrere Messskalen auszuwerten und zu einem Positionswert zu kombinieren. Damit sind Messsysteme möglich, die eine hohe integrale Genauigkeit oder sehr hohe Auflösungen mit guter differenzieller Genauigkeit bieten. Für die Abtastung genügt ein kleiner optischer Sensor.

Aus der EP 1 503 182 B1 ist ein Drehwinkelsensor bekannt. Der Drehwinkelsensor weist eine drehbare Welle, einen mit der drehbaren Welle gekoppelten Magneten und ein magnetempfindliches Sensorelement auf. Das Sensorelement erzeugt in Abhängigkeit vom relativen Drehwinkel zwischen dem Magneten und dem Sensor ein sinusförmiges und ein kosinusförmiges Ausgangssignal. Der Drehwinkelsensor weist eine Auswerteeinheit auf, die aus den Ausgangssignalen ein dem Drehwinkel entsprechendes Signal erzeugt. Die Welle ist längs einer Führungsbahn bei ihrer Drehung um ihre Achse zusätzlich linear parallel zu ihrer Achse verschieblich geführt, so dass sich der Abstand zwischen Magnet und Sensor entsprechend einer Steigung der Führungsbahn verändert. Die Auswerteeinheit ermittelt aus Ausgangssignalen des Sensorelementes ein Signal, aus welchem der Abstand zwischen dem Sensorelement und dem Magneten und damit die Anzahl der vollen Umdrehungen der Welle ermittelbar ist. Aus den sinusförmigen und kosinusförmigen Ausgangssignalen wird ein Feinsignal innerhalb einer vollen Umdrehung ermittelt und dieses Feinsignal wird zu dem Wert der vollen Umdrehung multipliziert mit 360° hinzuaddiert.

Vor diesem Hintergrund ist es die Aufgabe der vorliegenden Erfindung eine Schaltung anzugeben, die den Stand der Technik weiterbildet.

Diese Aufgabe wird durch ein Messsystem mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem Geber und mit einer Auswertungsschaltung vorgesehen.

Die Magnetfeldsensoranordnung weist einen in einem Halbleiterchip integrierten ersten Magnetfeldsensor zur Messung einer ersten Komponente eines Magnetfeldvektors in einer ersten Raumrichtung und einen im Halbleiterchip integrierten zweiten Magnetfeldsensor zur Messung einer zweiten Komponente des Magnetfeldvektors in einer zweiten Raumrichtung und einen im Halbleiterchip integrierten dritten Magnetfeldsensor zur Messung einer dritten Komponente des Magnetfeldvektors in einer dritten Raumrichtung auf.

Der Geber ist ausgebildet, in Abhängigkeit von seiner rotatorischen und/oder translatorischen Bewegung den Magnetfeldvektor in der ersten Raumrichtung und in der zweiten Raumrichtung und in der dritten Raumrichtung zu ändern. Der Magnetfeldvektor ist dabei am Ort der Magnetfeldsensoren durch die Messung der Komponenten des Magnetfeldvektors definiert. Die durch die Bewegung des Gebers bewirkte Änderung des Magnetfeldvektors beschreibt eine geschlossene und kreuzungsfreie Linie in allen drei Raumrichtungen.

An die Auswertungsschaltung sind der erste Magnetfeldsensor und der zweite Magnetfeldsensor und der dritte Magnetfeldsensor angeschlossen. Die Auswertungsschaltung ist eingerichtet, die Position des Gebers basierend auf einem ersten Messsignal des ersten Magnetfeldsensors und einem zweiten Messsignal des zweiten Magnetfeldsensors und einem dritten Messsignal des dritten Magnetfeldsensors zu bestimmen. Untersuchungen der Anmelderin zeigen, dass durch das Wesen der Erfindung, also durch den Verlauf des sensierten Magnetfeldvektors als geschlossene und kreuzungsfreie Linie in allen drei Raumrichtungen mehrere Vorteile erzielt werden. So ist jedem Magnetfeldvektor eine Position des Gebers eindeutig zuzuordnen. Zudem kann durch eine Vielzahl von Polwechsel eine hohe Auflösung erzielt werden. Zudem ist die Bewegung des Gebers nicht auf eine ausschließlich rotatorische oder auf eine ausschließlich transversale Bewegung beschränkt, sondern es können auch komplexere Bewegungsabläufe erfasst werden.

Gemäß einer vorteilhaften Weiterbildung ist die vom Magnetfeldvektor beschriebene Linie zumindest abschnittsweise schraubenlinienförmig.

In einer anderen vorteilhaften Weiterbildung ist der Geber ausgebildet, in Abhängigkeit von der rotatorischen und/oder translatorischen Bewegung eine Länge des Magnetfeldvektors zu modulieren. Eine derartige Amplitudenmodulation kann für eine oder mehrere Komponenten des Magnetfeldvektors in unterschiedlichen Raumrichtungen erfolgen.

Vorzugsweise weist die vom Magnetfeldvektor beschriebene Linie zumindest zwei ineinanderliegende schraubenlinienförmige Abschnitte auf. Bevorzugt sind die ineinanderliegenden schraubenlinienförmigen Abschnitte durch unterschiedliche Amplituden des Magnetfeldvektors in zumindest zwei Raumrichtungen voneinander distanziert.

Gemäß einer anderen vorteilhaften Weiterbildung ist der Geber ausgebildet, in Abhängigkeit von der rotatorischen und/oder translatorischen Bewegung des Gebers eine Steigung einer Schraubenlinienform der Linie des Magnetfeldvektors zu modulieren.

Gemäß einer anderen Weiterbildung ist der Geber ausgebildet, in Abhängigkeit von der rotatorischen und/oder translatorischen Bewegung eine erste Schwingung der ersten Komponente des Magnetfeldvektors mit einer ersten Frequenz und eine zweite Schwingung der zweiten Komponente des Magnetfeldvektors mit einer zweiten Frequenz zu modulieren, wobei die erste Frequenz und die zweite Frequenz unterschiedlich sind.

In einer vorteilhaften Ausgestaltung weist der Geber eine Anzahl von Magneten und/oder eine Anzahl von Spulen zur Erzeugung des Magnetfeldvektors auf.

In einer anderen vorteilhaften Ausgestaltung weist die Magnetfeldsensoranordnung eine Anzahl von Magneten und/oder eine Anzahl von Spulen zur Erzeugung des Magnetfeldvektors auf. Vorteilhafterweise wird der Magnetfeldvektor durch magnetisch leitfähiges Material des Gebers - beispielsweise durch Zähne von Zahnrädern - durch die Bewegung des Gebers verändert.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen

Fig. 1     eine schematische Darstellung eines Messsystems,

Fig. 2     einen Blockschaltplan,

Fig. 3     eine schematische Darstellung einer durch einen magnetischen Vektor beschriebenen Linie im dreidimensionalen Raum, und

Fig. 4     ein schematisches Diagramm mit Messsignalen.

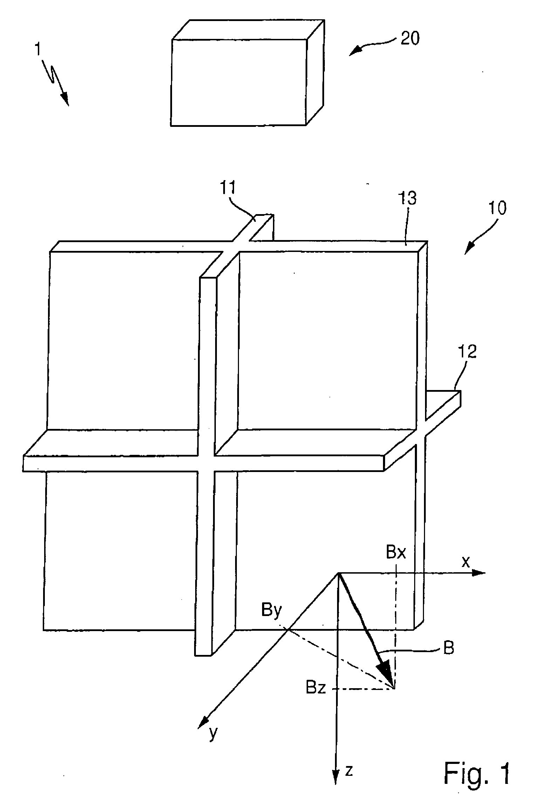

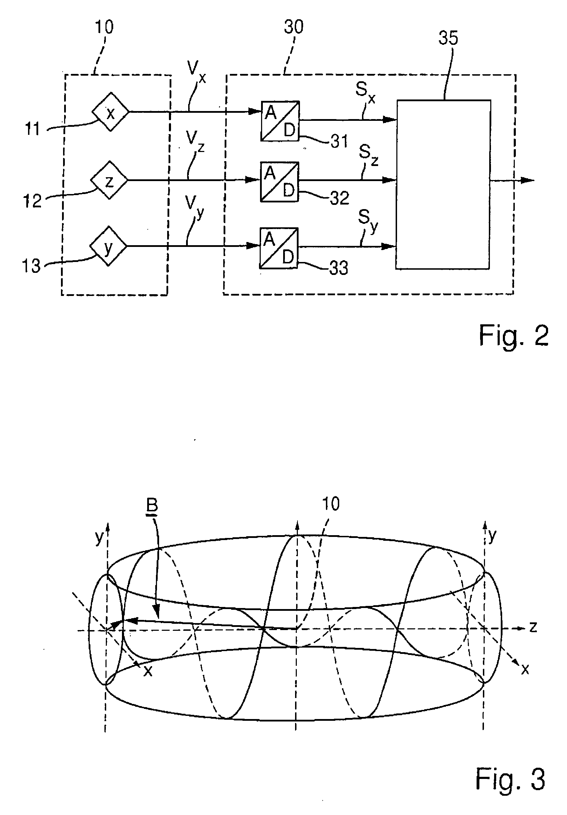

In Fig. 1 ist ein Messsystem 1 schematisch dargestellt. Das Messsystem 1 weist eine Magnetfeldsensoranordnung 10 und einen Geber 20 auf. An die Magnetfeldsensoranordnung 10 ist, wie in Fig. 2 schematisch dargestellt eine Auswertungsschaltung 30 angeschlossen.

In Fig. 1 ist zudem ein Koordinatenkreuz mit Raumrichtungen x, y und z schematisch dargestellt. Der Ursprung des Koordinatenkreuzes ist im Mittelpunkt der Magnetfeldsensoranordnung 10 angeordnet, in Fig. 1 für eine bessere Sichtbarkeit leicht versetzt gezeichnet. Weiterhin sind ein Magnetfeldvektor $\underline{B}$ - hier für die magnetische Flussdichte - und seine Komponenten $B_x$, $B_y$, $B_z$ in den Raumrichtungen x, y, z schematisch dargestellt. Die Magnetfeldsensoranordnung 10 weist einen ersten Magnetfeldsensor 11 und einen zweiten Magnetfeldsensor 12 und einen dritten Magnetfeldsensor 13 auf. Die Magnetfeldsensoren 11, 12, 13 sind in einem Halbeiterchip integriert. Die Magnetfeldsensoren 11, 12, 13 sind im Ausführungsbeispiel der Fig. 1 Hallsensoren. Alternativ können magnetresistive Sensoren oder Spulen als Magnetfeldsensoren 11, 12, 13 integriert sein.

Der erste Magnetfeldsensor 11 ist zur Messung der ersten Komponente $B_x$ des Magnetfeldvektors $\underline{B}$ in der ersten Raumrichtung x ausgebildet. Der zweite Magnetfeldsensor 12 ist zur Messung der zweiten Komponente $B_z$ des Magnetfeldvektors $\underline{B}$ in der zweiten Raumrichtung z ausgebildet. Der dritte Magnetfeldsensor 13 ist zur Messung der dritten Komponente $B_y$ des Magnetfeldvektors $\underline{B}$ in einer dritten Raumrichtung y ausgebildet.

Durch diese Magnetfeldsensoranordnung 10 ist eine besonders flexible Auswertung des Magnetfeldvektors $\underline{B}$ und damit der Position des Gebers 20 möglich. Fig. 3 zeigt eine Darstellung des magnetischen Vektors $\underline{B}$ im dreidimensionalen Raum (Kugelkoordinaten). Der magnetische Vektor B wird beispielsweise auf die X-Y-Ebene projiziert. Während einer Änderung des Magnetfeldes, beispielsweise durch Rotation, wird das Magnetfeld auch in z-Richtung moduliert. Der Magnetfeldvektor $\underline{B}$ beschreibt eine Schraubenlinie. Der Geber 20 ist somit ausgebildet, in Abhängigkeit von seiner rotatorischen und/oder translatorischen Bewegung den Magnetfeldvektor $\underline{B}$ in der ersten Raumrichtung x und in der zweiten Raumrichtung z und in der dritten Raumrichtung y zu ändern. Bleibt die Länge der Projektion des Vektors $\underline{B}$ auf die X-Y-Ebene konstant, führt dies zu Mehrdeutigkeiten an Kreuzungspunkten, da beispielsweise der Hinweg nicht vom Rückweg in den Kreuzungspunkten unterschieden werden kann. Daher wird im Ausführungsbeispiel der Fig. 2 zusammen mit der z-Modulation auch der Betrag der x-Komponente $B_x$ und der y-Komponente $B_y$ des Magnetfeldvektors $\underline{B}$ moduliert. Dabei wird der Vorteil erzielt, dass Mehrdeutigkeiten vermieden werden, indem im Ausführungsbeispiel der Fig. 3 die durch die Bewegung des Gebers 20 bewirkte Änderung des Magnetfeldvektors $\underline{B}$ eine geschlossene und kreuzungsfreie Linie in allen drei Raumrichtungen x, y, z beschreibt.

Abweichend von Fig. 3 können Geber vorgesehen sein, bei denen der Magnetfeldvektor B für einen kompletten Zyklus mehrere Spiralen in unterschiedlichen Ebenen nebeneinander durchläuft. Sobald der Vektor B in einer x-y-Ebene außen oder innen angekommen ist, springt er nicht in der gleichen x-y-Ebene nach innen oder außen sondern wechselt in die Nachbar-x-y-Ebene und läuft in der Nachbar-x-y-Ebene spiralförmig nach innen oder außen in gleicher Drehrichtung. In der letzten x-y-Ebene angekommen läuft der Vektor $\underline{B}$ helixförmig, auf einem Zylinder, ohne Kreuzung der bisherigen Vektorbahnen, zurück zum Anfang. Hingegen sind in Fig. 3 zwei ineinandergeschobene Spiralen zu erkennen, die ebenfalls eine geschlossene und kreuzungsfreie Linie in allen drei Raumrichtungen x, y, z beschreiben. Abweichend von Fig. 3 kann auch eine größere Anzahl von ineinandergeschobenen Spiralen genutzt werden.

In Fig. 2 ist ein Blockschaltplan mit einer Auswertungsschaltung 30 schematisch dargestellt. An die Auswertungsschaltung 30 sind der erste Magnetfeldsensor 11 und der zweite Magnetfeldsensor 12 und der dritte Magnetfeldsensor 13 der Magnetfeldsensoranordnung 10 angeschlossen. Jeder Magnetfeldsensor 11, 12, 13 gibt ein analoges Messsignal $V_x$, $V_y$, $V_z$ aus, das durch einen der Analog-Digital-Umsetzer 31, 32, 33 in ein digitales Messsignal $S_x$, $S_y$, $S_z$ umgesetzt wird. Die Auswertungsschaltung 30 weist eine Logik 35 auf. Die Logik 35 ist beispielsweise ein Prozessor. Mittels der Logik 35 ist die Auswertungsschaltung 30 eingerichtet, die Position des Gebers 30 basierend auf dem ersten Messsignal $S_x$ des ersten Magnetfeldsensors 11 und dem zweiten Messsignal $S_z$ des zweiten Magnetfeldsensors 12 und dem dritten Messsignal $S_y$ des dritten Magnetfeldsensors 13 zu bestimmen. Die Bestimmung der Position aus den Messsighafen $S_x$, $S_y$, $S_z$ kann beispielsweise mittels eines Algorithmus oder mittels Tabelle und Interpolation erfolgen.

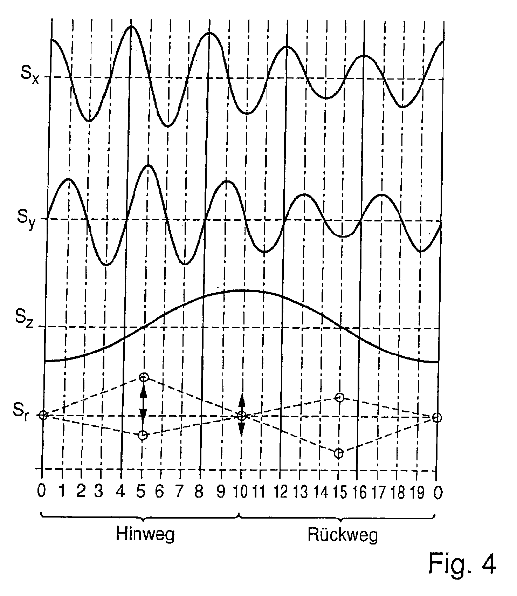

Fig. 4 zeigt die Signale $S_x$, $S_y$, $S_z$, $S_r$ für Hinweg und Rückweg entsprechend der Fig. 3 in einem schematischen Diagramm. Dabei gilt:

$$S_r = \sqrt{S_x^2 + S_y^2 + S_z^2} \qquad (1)$$

Das Signal $S_r$ ist der Betrag oder die Länge des Magnetfeldvektors B. Solange sich Hinweg und Rückweg genügend stark unterscheiden, hat man viele Variationsmöglichkeiten. Die beiden Umkehrpunkte müssen nicht, wie in Fig. 4 dargestellt, auf der gleichen Schale liegen. usw.

Die Erfindung ist nicht auf die dargestellten Ausgestaltungsvarianten der Figuren 1 bis 4 beschränkt. Beispielsweise ist es möglich, mit dem Geber 20 einen anderen Linienverlauf einer geschlossenen kreuzungsfreien Linie im dreidimensionalen Raum zu erzeugen. Die Funktionalität des Messsystems gemäß Fig. 1 kann besonders vorteilhaft für die Messung von Positionen und Bewegungen von Verstellsystemen verwendet werden.

Bezugszeichenliste

| | |
|---|---|
| 1 | Messsystem |
| 10 | Magnetfeldsensoranordnung |
| 11, 12, 13 | Magnetfeldsensor |
| 20 | Geber |

| | |
|---|---|
| 30 | Auswertungsschaltung |
| 31, 32, 33 | Analog-Digital-Umsetzer |
| 35 | Logik |
| $\underline{B}$ | Magnetfeldvektor |
| $B_x$, $B_y$, $B_z$ | Komponente des Magnetfeldvektors |
| $V_x$, $V_y$, $V_z$ | analoges Messsignal |
| $S_x$, $S_y$, $S_z$ | digitales Messsignal |
| x, y, z | Raumrichtung |

## Patentansprüche

1. Messsystem (1),

- mit einer Magnetfeldsensoranordnung (10), die einen in einem Halbeiterchip integrierten ersten Magnetfeldsensor (11) zur Messung einer ersten Komponente ($B_x$) eines Magnetfeldvektors ($\underline{B}$) in einer ersten Raumrichtung (x) und einen im Halbeiterchip integrierten zweiten Magnetfeldsensor (12) zur Messung einer zweiten Komponente ($B_z$) des Magnetfeldvektors ($\underline{B}$) in einer zweiten Raumrichtung (z) und einen im Halbeiterchip integrierten dritten Magnetfeldsensor (13) zur Messung einer dritten Komponente ($B_y$) des Magnetfeldvektors ($\underline{B}$) in einer dritten Raumrichtung (y) aufweist,
- mit einem Geber (20), der ausgebildet ist, in Abhängigkeit von seiner rotatorischen und/oder translatorischen Bewegung den Magnetfeldvektor ($\underline{B}$) in der ersten Raumrichtung (x) und in der zweiten Raumrichtung (z) und in der dritten Raumrichtung (y) zu ändern, und
- mit einer Auswertungsschaltung (30), an die der erste Magnetfeldsensor (11) und der zweite Magnetfeldsensor (12) und der dritte Magnetfeldsensor (13) angeschlossen sind,
- wobei die Auswertungsschaltung (30) eingerichtet ist, die Position des Gebers (20) basierend auf einem ersten Messsignal ($S_x$) des ersten Magnetfeldsensors (11) und einem zweiten Messsignal ($S_z$) des zweiten Magnetfeldsensors (12) und einem dritten Messsignal ($S_y$) des dritten Magnetfeldsensors (13) zu bestimmen,

**dadurch gekennzeichnet, dass**

- zusammen mit der z-Modulation auch der Betrag der x-Komponente ($B_x$) und der y-Komponente ($B_y$) des Magnetfeldvektors ($\underline{B}$) moduliert ist und bei einer Projektion des Vektors ($\underline{B}$) auf die X-Y-Ebene die Länge der Projektion des Magnetfeldvektors ($\underline{B}$) nicht konstant bleibt, und
- der Magnetfeldvektor ($\underline{B}$) für einen kompletten Zyklus mehrere Spiralen in unterschiedlichen Ebenen nebeneinander durchläuft und sobald der Vektor ($\underline{B}$) in einer x-y-Ebene außen oder innen angekommen ist, der Magnetfeldvektor ($\underline{B}$) in die Nachbar-x-y-Ebene wechselt und in der Nachbar-x-y-Ebene spiralförmig nach innen oder außen in gleicher Drehrichtung und sobald in der letzten x-y-Ebene angekommen läuft der Vektor ($\underline{B}$) helixförmig, auf einem Zylinder, ohne Kreuzung der bisherigen Vektorbahnen, zurück zum Anfang,
- so dass in beiden Fällen die durch die Bewegung des Gebers (10) bewirkte Änderung des Magnetfeldvektors ($\underline{B}$) eine geschlossene und kreuzungsfreie Linie in allen drei Raumrichtungen (x, y, z) beschreibt.

2. Messsystem (1) nach Anspruch 1,
**dadurch gekennzeichnet, dass**
die vom Magnetfeldvektor ($\underline{B}$) beschriebene Linie zumindest abschnittsweise schraubenlinienförmig ist.

3. Messsystem (1) nach einem der vorhergehenden Ansprüche,
**dadurch gekennzeichnet, dass**
die vom Magnetfeldvektor ($\underline{B}$) beschriebene Linie zumindest zwei ineinanderliegende schraubenlinienförmige Abschnitte aufweist.

4. Messsystem (1) nach einem der vorhergehenden Ansprüche,
**dadurch gekennzeichnet, dass**
der Geber (20) ausgebildet ist, in Abhängigkeit von der rotatorischen und/oder translatorischen Bewegung eine Steigung einer Schraubenlinienform der Linie des Magnetfeldvektors ($\underline{B}$) zu modulieren.

5. Messsystem (1) nach einem der vorhergehenden Ansprüche,
**dadurch gekennzeichnet, dass**

der Geber (20) ausgebildet ist, in Abhängigkeit von der rotatorischen und/oder translatorischen Bewegung eine erste Schwingung der ersten Komponente ($B_x$) des Magnetfeldvektors ($\underline{B}$) mit einer ersten Frequenz und eine zweite Schwingung der zweiten Komponente ($B_z$) des Magnetfeldvektors ($\underline{B}$) mit einer zweiten Frequenz zu modulieren, wobei die erste Frequenz und die zweite Frequenz unterschiedlich sind.

6. Messsystem (1) nach einem der vorhergehenden Ansprüche,
**dadurch gekennzeichnet, dass**
zur Erzeugung des Magnetfeldvektors ($\underline{B}$) der Geber (20) eine Anzahl von Magneten und/oder eine Anzahl von Spulen aufweist.

7. Messsystem (1) nach einem der vorhergehenden Ansprüche,
**dadurch gekennzeichnet, dass**
zur Erzeugung des Magnetfeldvektors ($\underline{B}$) die Magnetfeldsensoranordnung (10) eine Anzahl von Magneten und/oder eine Anzahl von Spulen aufweist.

**Claims**

1. Measuring system (1)

   - with a magnetic field sensor arrangement (10), which comprises a first magnetic field sensor (11) integrated in a semiconductor chip and for measuring a first component ($B_x$) of a magnetic field vector ($\underline{B}$) in a first dimensional direction (x), a second magnetic field sensor (12) integrated in the semiconductor chip and for measuring a second component ($B_z$) of the magnetic field vector ($\underline{B}$) in a second dimensional direction (z) and a third magnetic field sensor (13) integrated in the semiconductor chip and for measuring a third component ($B_y$) of the magnetic field vector ($\underline{B}$) in a third dimensional direction (y),
   - with a transmitter (20), which is constructed to change, in dependence on its rotational and/or translational movement, the magnetic field vector ($\underline{B}$) in the first dimensional direction (x), the second dimensional direction (z) and the third dimensional direction (y), and
   - with an evaluating circuit (30) with which the first magnetic field sensor (11), the second magnetic field sensor (12) and the third magnetic field sensor (13) are connected,
   - wherein the evaluating circuit (30) is arranged to determine the position of the transmitter (20) based on a first measurement signal ($S_x$) of the first magnetic field sensor (11), a second measurement signal ($S_z$) of the second magnetic field sensor (12) and a third measurement signal ($S_y$) of the third magnetic field sensor (13),

   **characterised in that**

   - together with the z-modulation the amount of the x-component ($B_x$) and the y-component ($B_y$) of the magnetic field vector ($\underline{B}$) is also modulated and in the case of projection of the vector ($\underline{B}$) on the X-Y plane the length of the projection of the magnetic field vector ($\underline{B}$) does not remain constant, and
   - the magnetic field vector ($\underline{B}$) for a complete cycle runs through several spirals in different planes adjacent to one another and as soon as the vector ($\underline{B}$) has arrived in an x-y plane at the outside or inside the magnetic field vector ($\underline{B}$) changes to the adjacent x-y plane and runs spirally inwardly or outwardly in the same direction in the adjacent x-y plane and as soon as it arrives in the last x-y plane the vector ($\underline{B}$) runs helically on a cylinder back to the start without crossing the previous vector paths
   - so that in both cases the change, which is produced by the movement of the transmitter (10), of the magnetic field vector ($\underline{B}$) describes a closed and intersection-free line in all three dimensional directions (x, y, z).

2. Measuring system (1) according to claim 1, **characterised in that** the line described by the magnetic field vector ($\underline{B}$) is helical at least in a section.

3. Measuring system (1) according to one of the preceding claims, **characterised in that** the line described by the magnetic field vector ($\underline{B}$) has at least two helical sections lying one in the other.

4. Measuring system (1) according to any one of the preceding claims, **characterised in that** the transmitter (20) is constructed to modulate a gradient of a helical shape of the line of the magnetic field vector ($\underline{B}$) in dependence on the rotational and/or translational movement.

**5.** Measuring system (1) according to any one of the preceding claims, **characterised in that** the transmitter (20) is constructed to modulate a first oscillation of the first component ($B_x$) of the magnetic field vector ($\underline{B}$) at a first frequency and a second oscillation of the second component ($S_z$) of the magnetic field vector ($\underline{B}$) at a second frequency in dependence on the rotational and/or translational movement, wherein the first frequency and the second frequency are different.

**6.** Measuring system (1) according to any one of the preceding claims, **characterised in that** for generating the magnetic field vector ($\underline{B}$) the transmitter (20) comprises a plurality of magnets and/or a plurality of coils.

**7.** Measuring system (1) according to any one of the preceding claims, **characterised in that** for generating the magnetic field vector ($\underline{B}$) the magnetic field sensor arrangement (10) comprises a plurality of magnets and/or a plurality of coils.

**Revendications**

**1.** Système de mesure (1),

- avec un agencement de détecteurs de champ magnétique (10) qui présente un premier détecteur de champ magnétique (11) intégré dans une puce à semi-conducteur pour la mesure d'une première composante ($B_x$) d'un vecteur champ magnétique ($\underline{B}$) dans une première direction de l'espace (x) et un deuxième détecteur de champ magnétique (12) intégré dans la puce à semi-conducteur pour la mesure d'une deuxième composante ($B_z$) du vecteur champ magnétique ($\underline{B}$) dans une deuxième direction de l'espace (z) et un troisième détecteur de champ magnétique (13) intégré dans la puce à semi-conducteur pour la mesure d'une troisième composante ($B_y$) du vecteur champ magnétique ($\underline{B}$) dans une troisième direction de l'espace (y),
- avec un émetteur (20) qui est conçu pour modifier, en fonction de son mouvement de rotation et/ou de translation, le vecteur champ magnétique (B) dans la première direction de l'espace (x) et dans la deuxième direction de l'espace (z) et dans la troisième direction de l'espace (y), et
- avec un circuit d'exploitation (30), auquel le premier détecteur de champ magnétique (11) et le deuxième détecteur de champ magnétique (12) et le troisième détecteur de champ magnétique (13) sont reliés,
- dans lequel le circuit d'exploitation (30) est conçu pour déterminer la position de l'émetteur (20) en se basant sur un premier signal de mesure ($S_x$) du premier détecteur de champ magnétique (11) et un deuxième signal de mesure ($S_z$) du deuxième détecteur de champ magnétique (12) et un troisième signal de mesure ($S_y$) du troisième détecteur de champ magnétique (13),

**caractérisé en ce que**

- avec la modulation z, la valeur de la composante x (B) et de la composante y ($B_y$) du vecteur champ magnétique ($\underline{B}$) est également modulée et, lors d'une projection du vecteur ($\underline{B}$) sur le plan x-y, la longueur de la projection du vecteur champ magnétique ($\underline{B}$) ne reste pas constante, et
- le vecteur champ magnétique ($\underline{B}$) décrit pour un cycle complet plusieurs spirales dans des plans différents l'un à côté de l'autre et dès que le vecteur ($\underline{B}$) est arrivé à l'extérieur ou à l'intérieur dans un plan x-y, le vecteur champ magnétique ($\underline{B}$) passe dans le plan x-y voisin et dans le plan x-y voisin en forme de spirale vers l'intérieur ou l'extérieur dans le même sens de rotation et dès qu'il est arrivé dans le dernier plan x-y, le vecteur ($\underline{B}$) revient au début en forme d'hélice, sur un cylindre, sans croiser les traces de vecteur précédentes,
- de telle manière que dans les deux cas, la modification du vecteur champ magnétique ($\underline{B}$) provoquée par le mouvement de l'émetteur (10) décrive une ligne fermée et sans croisements dans les trois directions de l'espace (x, y, z).

**2.** Système de mesure (1) selon la revendication 1, **caractérisé en ce que** la ligne décrite par le vecteur champ magnétique ($\underline{B}$) est une ligne au moins localement hélicoïdale.

**3.** Système de mesure (1) selon l'une quelconque des revendications précédentes, **caractérisé en ce que** la ligne décrite par le vecteur champ magnétique ($\underline{B}$) présente au moins deux parties hélicoïdales disposées l'une dans l'autre.

**4.** Système de mesure (1) selon l'une quelconque des revendications précédentes, **caractérisé en ce que** l'émetteur (20) est configuré pour moduler, en fonction du mouvement de rotation et/ou de translation, une pente d'une forme hélicoïdale de la ligne du vecteur champ magnétique ($\underline{B}$).

5. Système de mesure (1) selon l'une quelconque des revendications précédentes, **caractérisé en ce que** l'émetteur (20) est configuré pour moduler, en fonction du mouvement de rotation et/ou de translation, une première oscillation de la première composante ($B_x$) du vecteur champ magnétique ($\underline{B}$) avec une première fréquence et une deuxième oscillation de la deuxième composante ($B_z$) du vecteur champ magnétique ($\underline{B}$) avec une deuxième fréquence, la première fréquence et la deuxième fréquence étant différentes.

6. Système de mesure (1) selon l'une quelconque des revendications précédentes, **caractérisé en ce que**, pour la production du vecteur champ magnétique ($\underline{B}$), l'émetteur présente un nombre d'aimants et/ou un nombre de bobines.

7. Système de mesure (1) selon l'une quelconque des revendications précédentes, **caractérisé en ce que**, pour la production du vecteur champ magnétique ($\underline{B}$), l'agencement de détecteurs de champ magnétique (10) présente un nombre d'aimants et/ou un nombre de bobines.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2354769 A1
- US 2012262157 A1
- US 2008044119A1 A
- JP 2003194901 A
- EP 2339299 A2
- WO 2012060216 A1
- DE 102008059401 A1
- EP 1111392 A1
- EP 1503182 B1

**In der Beschreibung aufgeführte Nicht-Patentliteratur**

- **J. QUASDORF.** *ELEKTRONIK PRAXIS,* 17. September 2008, 22